# EUROPEAN PATENT SPECIFICATION

(11) **EP 3 437 854 B1**
(45) Date of publication and mention of the grant of the patent: **21.07.2021**
(21) Application number: 17774755.7
(22) Date of filing: 24.03.2017
(51) Int. Cl.: C03C 17/34, B32B 9/04

(54) **MULTILAYER FILM, OPTICAL MEMBER, AND OPTICAL MEMBER MANUFACTURING METHOD**
MEHRSCHICHTFOLIE, OPTISCHES ELEMENT UND VERFAHREN ZUR HERSTELLUNG EINES OPTISCHEN ELEMENTS
FILM MULTICOUCHE, ÉLÉMENT OPTIQUE, ET PROCÉDÉ DE FABRICATION D'ÉLÉMENT OPTIQUE

(30) Priority: 29.03.2016 JP 2016066149
(43) Date of publication of application: 06.02.2019
(73) Proprietor: Canon Optron Inc., Yuki-shi, Ibaraki 307-0015 (JP)
(72) Inventor: WATARAI, Takanori, Yuki-shi Ibaraki 307-0015 (JP); TAMEKUNI, Takahiro, Yuki-shi Ibaraki 307-0015 (JP); NUMAZAWA, Hiroto, Yuki-shi Ibaraki 307-0015 (JP); HORIE, Yukihiro, Yuki-shi Ibaraki 307-0015 (JP)
(74) Representative: TBK
(86) International application number: PCT/JP2017/011987
(87) International publication number: WO 2017/170218

(56) References cited:
- JP-A- H09 174 750
- JP-A- 2000 226 533
- JP-A- 2001 356 201
- JP-A- 2003 231 827
- JP-A- 2006 076 829
- US-A1- 2003 152 763
- US-B1- 6 716 513

## Description

### [Technical Field]

The present invention relates to a multilayer film and an optical member.

### [Background Art]

As for industrial use of thin films, in recent years, various studies are being carried out, which include studies for forming a thin film having a water repellent or hydrophilic function, in addition to a conventional optical thin film, protective film and the like. These optical thin films have been conventionally used for an antireflection film of eyeglasses, displays and the like, but in recent years, the optical thin films have been applied to an antifogging film and an antifouling film which impart a hydrophilic or water repellent function to a cover glass of a mobile phone and side mirrors of a car.

Among the films, the antifogging film is a film that removes fogging which occurs on glass, a resin, a metal or a composite material thereof by utilizing the hydrophilic function of making a water droplet become wet and spread on a surface of a member.

In PTL 1, there is described a substrate which is characterized in that the substrate has an underlayer which is formed of an alumina layer or a mixed layer of alumina and silica, and a hydrophilic layer which has hydrophilicity and contains phosphorus, silicon and oxygen on the underlayer, provided thereon.

US 6 716 513 B1 describes a hydrophilic material which comprises a substrate and a hydrophilic layer provided as the outermost layer on the substrate. The hydrophilic layer comprises hydrophilic metal oxide particles and a hydrophilic inorganic amorphous material. The hydrophilic layer has profile peaks on its surface.

US 2003/152763 A1 describes an anti-fogging coating material which comprises a phosphoric acid compound binder; and oxide particles having an average particle diameter of 1 to 300 nm mixed with the phosphoric acid compound binder.

### [Citation List]

### [Patent Literature]

PTL 1: Japanese Patent Application Laid-Open No. 2000-226533

### [Summary of Invention]

### [Technical Problem]

However, the coated film of the hydrophilic film in the form of having the underlayer that is the layer which contains alumina as described above has not shown sufficient sustainability of a hydrophilic performance against repeated wiping.

The present invention is made in view of the conventional technology described above, and is directed at providing a multilayer film and an optical member of which the surfaces are excellent in the sustainability of the hydrophilic performance.

### [Solution to Problem]

The present invention is a multilayer film defined in claim 1.

The present invention is also an optical member including: a substrate; and a multilayer film that covers a surface of the substrate, wherein the multilayer film is defined in claim 1.

### [Advantageous Effects of Invention]

The present invention can provide a multilayer film and an optical member of which the surfaces show the excellent sustainability of the hydrophilic performance.

### [Brief Description of Drawings]

[Fig. 1]

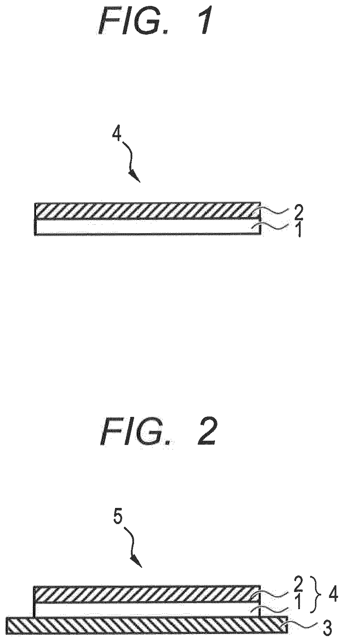

   Fig. 1 is a cross-sectional view showing an embodiment of a multilayer film of the present invention.
[Fig. 2]
   Fig. 2 is a cross-sectional view showing an embodiment of an optical member of the present invention.
[Fig. 3]

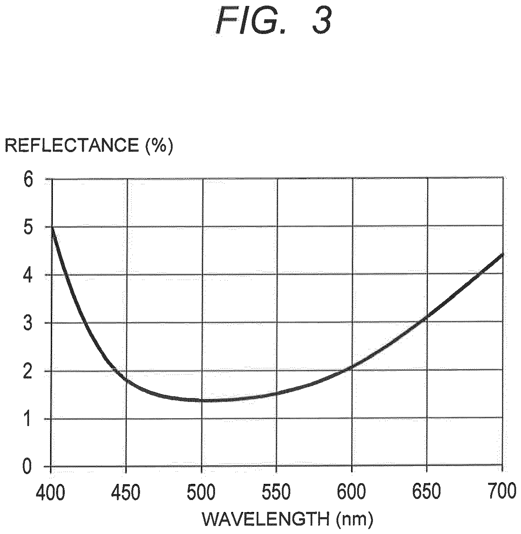

   Fig. 3 is a diagram showing a reflectance of an antireflection film in another embodiment.
[Fig. 4]

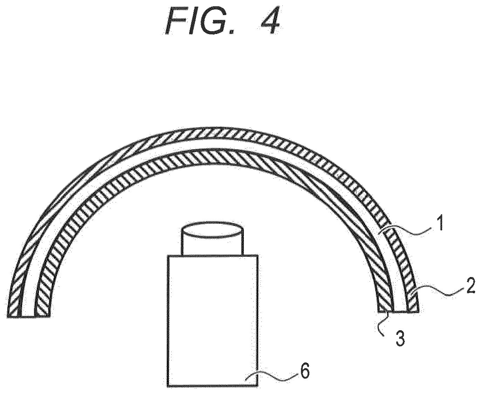

   Fig. 4 is a cross-sectional view showing an example in which the multilayer film of the present invention is applied to a camera cover.

### [Description of Embodiments]

Hereinafter, embodiments of the present invention will be described, but the present invention is not limited to the following embodiments.

A cross-sectional view of one embodiment of a multilayer film of the present invention is shown in Fig. 1. The multilayer film 4 shown in Fig. 1 has an underlayer 1 that is used for covering the surface of a substrate and is arranged on the surface of the substrate, and a hydrophilic layer 2 that is layered on the underlayer 1. Furthermore, the underlayer 1 contains aluminum oxide and zirconium oxide or hafnium oxide and the hydrophilic layer 2 contains phosphoric acid.

A cross-sectional view of one embodiment of an optical member of the present invention is shown in Fig. 2. The optical member 5 shown in Fig. 2 has a substrate 3, and the multilayer film 4 shown in Fig. 1 described above, which covers the surface of the substrate 3.

Here, as the substrate 3, glass, plastic, and furthermore, glass or plastic on the surface of which a functional film such as an optical thin film and a conductive film is formed are applied.

The multilayer film 4 shown in Fig. 1 is layered on the substrate 3 such that the hydrophilic layer 2 becomes the surface layer, as is shown in Fig. 2, and thereby can impart the hydrophilic performance onto the surface of the substrate 3; and the hydrophilic performance has excellent sustainability.

In the present invention, an influence of the multilayer film in which the hydrophilic layer containing phosphoric acid is layered on the underlayer containing the aluminum oxide and the zirconium oxide or hafnium oxide,
on the sustainability of the surface hydrophilic performance, will be described in detail below.

It is considered that when the hydrophilic layer containing phosphoric acid is layered directly on the substrate without through the underlayer, the hydrophilic layer is bonded to the substrate by physical adsorption between the phosphoric acid and the substrate. In this case, the bond between the substrate and the hydrophilic layer is insufficient, and accordingly the hydrophilic layer results in being easily peeled from the substrate due to a wiping operation. In addition, phosphoric acid which is not bonded reacts with moisture in the atmosphere, thereby the surface state of the hydrophilic film changes, and the adhesion of nitrogen, dust or the like in the atmosphere to the surface becomes easy to occur. In addition, when a substance such as calcium phosphate is used for the hydrophilic layer, the production of an aggregate of calcium oxide occurs on the surface of the hydrophilic layer. As a result, it becomes difficult that water droplets and the like become wet and spread on the surface of the hydrophilic layer, and the hydrophilic performance results in being lowered.

By the way, phosphoric acid tends to easily take a form of trivalent negative ions, and accordingly tends to easily react with a metal that can be trivalent or hexavalent. For this reason, if the underlayer containing the compound of a metal which can be trivalent or hexavalent exists between the hydrophilic layer containing the phosphoric acid and the substrate, the metal of the underlayer reacts with the phosphoric acid in the hydrophilic layer to produce a poorly soluble phosphoric acid compound. As a result, it is considered that the reaction between the phosphoric acid and moisture in the atmosphere becomes difficult to occur, which suppresses the lowering of the hydrophilic performance at the time when the multilayer has been exposed to a high-temperature and high-humidity environment.

In the present invention, the compound of the metal contained in the underlayer is aluminum oxide. By this compound being contained, the multilayer film can enhance the sustainability of the hydrophilic performance.

In addition, when transparency is important for the application of the hydrophilic multilayer film, the aluminum oxide is contained. If a large amount of aluminum oxide is contained in the thin film, the poorly soluble aluminum phosphate is generated in the hydrophilic layer, and it is easy to obtain a transparent film also for the underlayer.

Furthermore, the present inventors have found that the multilayer film can further enhance the sustainability of the hydrophilic performance, by making the metal of which the electronegativity is largely different from that of oxygen which constitutes the phosphoric acid in the hydrophilic layer exist in the underlayer. It is considered that the existence of the metal of which the electronegativity is largely different from that of the oxygen constituting the phosphoric acid in the hydrophilic layer can enhance an ionic bond between the phosphoric acids in the hydrophilic layer, under the influence of high ionicity of the metal element, and in addition, can enhance also a bonding force between the underlayer and the substrate.

In the present invention, it is preferable that a compound of a metal of which electronegativity is largely different from that of the oxygen, which is contained in the underlayer, is zirconium (electronegativity of 1.4) or hafnium (electronegativity of 1.3). Here, the value of the electronegativity in the present invention is a value of Pauli's electronegativity.

In addition, in the present invention that the compound of a metal of which electronegativity is different from that of oxygen by 2.1 or more, which is contained in the underlayer, is zirconium oxide or hafnium oxide. Of course, a plurality kind of compounds of these metals may be contained. In particular, an embodiment in order to enhance the sustainability of the hydrophilic performance of the multilayer film is an embodiment in which zirconium oxide or hafnium oxide is contained in the underlayer, and particularly preferably is an embodiment in which the zirconium oxide is contained in the underlayer.

In the present invention described above, the underlayer contains aluminum oxide, and thereby aluminum oxide in the underlayer reacts with the phosphoric acid in the hydrophilic layer to produce a poorly soluble substance on an interface between the underlayer and the hydrophilic layer, which can suppress a reaction with moisture in the atmosphere. Thereby, it becomes possible to suppress that substances other than moisture in the atmosphere adhere to the surface of the hydrophilic film, and that a foreign substance originating in the phosphate compound is formed, and to maintain the hydrophilic performance. Furthermore, due to the underlayer containing the compound of the metal of which the electronegativity is largely different from that of oxygen, it becomes possible to electrically enhance a bonding force between the phosphoric acids, and further to enhance also a bonding force between the hydrophilic layer and the substrate; and accordingly the multilayer film can enhance the sustainability of the hydrophilic performance.

In addition, according to the findings described above, it is considered that the multilayer film in which the underlayer contains aluminum oxide and zirconium oxide, and the hydrophilic layer contains phosphoric acid is a particularly preferable embodiment for the present invention.

In the underlayer of the present invention, for enhancing the sustainability of the hydrophilic performance, a ratio of the weight of the zirconium oxide or hafnium oxide to the total weight of the zirconium oxide or hafnium oxide and the aluminum oxide is in the range of 50% or less, and is preferable that the weight ratio is in the range of 5% to 50%.

In addition, in the present invention, it is preferable that a thickness of the underlayer is in the range of 1 nm to 100 nm, and on the other hand, it is preferable that a thickness of the hydrophilic layer is in the range of 10 nm to 250 nm.

The multilayer film according to the present invention can be formed on various substrates. The specific examples include substrates such as float glass, quartz, sapphire and polycarbonate. In addition, the multilayer film according to the present invention is transparent, and accordingly by being formed on the transparent substrate described above, can provide an optical member having a hydrophilic function.

As for examples of the optical member having the hydrophilic function, there are eyeglasses, goggles, displays, touch panels and cameras. In particular, in the case of a security camera which is used in outdoors, it is disadvantageous for acquiring image information that a vision is blocked by the attachment of water droplets.

In addition, the multilayer film of the present invention can be formed by a step of forming an underlayer by using a material containing aluminium oxide and zirconium oxide or hafnium oxide; and a step of forming a hydrophilic layer on a surface of the underlayer by using a material containing phosphoric acid.

In addition, a method for producing an optical member of the present invention includes: a step of forming an underlayer on a surface of a substrate, by using a material containing aluminum oxide and zirconium oxide or hafnium oxide; and a step of forming a hydrophilic layer on a surface of the underlayer by using a material containing phosphoric acid.

In addition, in the method for producing the optical member according to the present invention, it is preferable that the underlayer and the hydrophilic layer are formed particularly by a vapor deposition method.

The vapor deposition method is a technique of heating a vapor deposition material in a vacuum chamber, depositing a component of a volatilized vapor deposition material on a substrate, and forming a thin film on the substrate. Examples of the method for heating the vapor deposition material include an electron gun, resistance heating and plasma. In addition, it is also possible to modify the film by controlling an atmosphere by a gas flow such as oxygen and hydrogen into the vacuum chamber. Examples of the shape of the vapor deposition material include a pellet shape and a granular shape, but are not limited to these shapes.

According to the vapor deposition method, it is easy to control a film thickness precisely in a nano-order, and accordingly also in a case where an optical multilayer film such as an antireflection film is combined with the multilayer film of the present invention, it is possible to impart a surface hydrophilic performance having high sustainability, without hindering a design for the optical multilayer film.

In addition, in the method for producing the optical member of the present invention, as for the material for forming the underlayer, it is preferable for enhancing the sustainability of the hydrophilic performance that a ratio of a weight of the compound of zirconium oxide or hafnium oxide to a total weight of aluminum oxide is set to be in the range of 9% to 90%, and is more preferable that the weight ratio is set to be particularly in the range of 17% to 33%.

In addition, it is preferable that the underlayer is formed such that the thickness is in the range of 1 nm to 100 nm, and the hydrophilic layer is formed such that the thickness is in the range of 10 nm to 250 nm.

### [Examples]

Hereinafter, the present invention will be described in detail with reference to examples and comparative examples. However, the present invention is not limited to these examples at all.

### (Example 1)

### <Production of vapor deposition material to be used for film formation of underlayer>

Aluminum oxide (fine white powder, average particle size of 0.6 µm, and purity of 99.9% or more) and zirconium oxide (white powder, average particle size of 20 µm, and purity of 99.9% or more) were placed in an alumina mortar at a weight ratio of Al₂O₃:ZrO₂ = 83:17; and furthermore an organic binder (mixed solution of fatty acid emulsion, polyoxyethylene sorbitane monooleate, glycerin, triethanolamine salt of polyacrylic acid, and pure water) with a weight of 7% of the powder placed was added to the alumina mortar, followed by mixing to prepare a mixed powder.

The obtained mixed powder in an amount of 15 g was placed in a die with a diameter of 30 mm, and then was formed into a pellet with a columnar shape by a uniaxial pressing machine. After that, the pellet was heated at 1500°C for 10 hours with the use of a box-type muffle firing apparatus, and was formed into a metal-oxide vapor deposition material for the film formation of the underlayer.

### <Production of vapor deposition material used for film formation of hydrophilic layer>

An appropriate amount of pure water was added to calcium phosphate (white powder, average particle diameter of 10 µm, and purity of 98% or more); and the mixture was kneaded and then sieved, and was formed into a granule shape with a size of 1 to 2 mm. The obtained granules were placed in a box-type muffle firing apparatus, and were heated at 1200°C for 2 hours; and a phosphoric acid vapor deposition material for the film formation of a hydrophilic layer was formed.

### <Film formation>

A vacuum vapor deposition apparatus (dome diameter of 900 mm ϕ and vapor deposition distance of 890 mm) was used, float glass (diameter of 74.5 mm and thickness of 1.1 mm) was placed in the dome as a substrate, and furthermore, the metal-oxide vapor deposition material for the underlayer and the phosphoric acid vapor deposition material for the hydrophilic layer which was prepared by the above described method were placed in the vapor deposition apparatus. The inside of the chamber was depressurized, and in a state in which the shutter was closed, the phosphoric acid vapor deposition material was irradiated with an electron beam for 5 minutes to be melted.

Next, the metal-oxide vapor deposition material for the underlayer was irradiated with an electron beam, the vaporized component was deposited on the substrate, and an underlayer film having a thickness of 10 nm was formed. At this time, the starting degree of vacuum was 2.0×10⁻³ Pa or lower, a film formation rate was 2 Å/sec, and film formation was under an oxygen gas flow. Furthermore, the melted phosphoric acid vapor deposition material was irradiated with an electron beam, the vaporized component was deposited on the underlayer, and a hydrophilic layer having a thickness of 100 nm was formed. At this time, the film formation rate was 2 Å/sec, and film formation was under an oxygen gas flow.

The vacuum apparatus was returned to the atmospheric pressure, the substrate was taken out in which the multilayer film formed of the underlayer and the hydrophilic layer was film-formed on the float glass substrate, and a film-formed substrate was prepared.

### <Evaluation of hydrophilic performance>

With the use of a contact angle meter CA-X 150 made by Kyowa Interface Science Co., Ltd., 2.5 µL of pure water was added dropwise to the film surface of the film-formed substrate, and a contact angle was measured by an image-processing method. The contact angle was 6.3°, and the film-formed substrate showed an excellent hydrophilic performance.

### <Wiping test of film-formed substrate>

The film-formed substrate was stored and cooled in a refrigerator at approximately 4 ° C for 8 hours or longer. With the use of a steam humidifier KS 1-A 083 made by YAMAZEN Corporation, steam was sprayed onto the cooled film-formed substrate for 20 seconds from a position approximately 2 cm away from the opening of the steam humidifier. The film-formed substrate on which moisture was deposited by the spray of steam was wiped off with an industrial wiper.

The steam spraying operation onto the cooled substrate was repeated 5 times, and a substrate for measurement was prepared. With the use of a contact angle meter CA-X 150 made by Kyowa Interface Science Co., Ltd., 2.5 µL of pure water was added dropwise to the film surface of the substrate for measurement, and the contact angle was measured by an image-processing method. The contact angle was 9.7°, and the substrate for measurement maintained an excellent hydrophilic performance.

### <Observation of appearance after moisture resistance test of film-formed substrate>

The film-formed substrate was placed in a thermostatic bath PL1-KP made by Espec Corp., and was stored for 150 hours or longer in an environment at 60°C and 90% RH; and a substrate for observation was prepared. The film surface of the substrate for observation was observed with the use of a manipulator APS-001 made by Micro Support Co. Ltd., and the presence or absence of turbidity and/or a foreign matter was checked. In the observed screen, a ratio occupied by the foreign matter was 20% or less.

### <Composition analysis of multilayer film>

Components of a film-semi-formed substrate where only a metal-oxide vapor deposition material was formed on a float glass substrate, with the use of a fluorescent X-ray analysis (XRF) apparatus ZSX Primus 2 made by Rigaku Corporation were analyzed, and as a result, zirconium and aluminum were detected as the components of the underlayer. The weight ratio at this time was a ratio of Al₂O₃:ZrO₂ = 92.4:7.6.

In addition, components of a film-formed substrate where the underlayer was formed on the float glass substrate and a calcium phosphate vapor deposition material was further formed thereon were analyzed, and as a result, zirconium, aluminum, phosphorus and calcium were detected as the components of the multilayer film.

### (Example 2)

Aluminum oxide (fine white powder, average particle size of 0.6 µm, and purity of 99.9% or more) and zirconium oxide (white powder, average particle diameter of 20 µm, and purity of 99.9% or more) were mixed at a weight ratio of Al₂O₃:ZrO₂ = 77:23, and were prepared in a similar method to that in Example 1, as a mixed powder to be used for the preparation of a metal-oxide vapor deposition material for the film formation of an underlayer.

A film-formed substrate was prepared with the use of the phosphoric acid vapor deposition material for the film formation of the hydrophilic layer, which was prepared by the method for Example 1, and was subjected to the measurement and evaluation, in a similar way to that in Example 1; and as a result, peeling of the hydrophilic layer did not occur, a contact angle after the wiping test was 9.4°, and in the observed screen, a ratio occupied by the foreign matter was 20% or less. In addition, a weight ratio between zirconium and aluminum in the formed underlayer was a ratio of Al₂O₃:ZrO₂ = 93.2:6.8.

### (Example 3)

Aluminum oxide (fine white powder, average particle size of 0.6 µm, and purity of 99.9% or more) and zirconium oxide (white powder, average particle diameter of 20 µm, and purity of 99.9% or more) were mixed at a weight ratio of Al₂O₃:ZrO₂ = 67:33, and were prepared in a similar method to that in Example 1, as a mixed powder to be used in the preparation of a metal-oxide vapor deposition material for the film formation of an underlayer.

A film-formed substrate was prepared with the use of the phosphoric acid vapor deposition material for the film formation of the hydrophilic layer, which was prepared by the method for Example 1, and was subjected to the measurement and evaluation, in a similar way to that in Example 1; and as a result, peeling of the hydrophilic layer did not occur, a contact angle after the wiping test was 8.6°, and in the observed screen, a ratio occupied by the foreign matter was 20% or less. In addition, a weight ratio between aluminum oxide and zirconium oxide in the formed underlayer was a ratio of Al₂O₃:ZrO₂ = 93.1:6.9.

### (Example 4)

Aluminum oxide (fine white powder, average particle size of 0.6 µm, and purity of 99.9% or more) and zirconium oxide (white powder, average particle diameter of 20 µm, and purity of 99.9% or more) were mixed at a weight ratio of Al₂O₃: ZrO₂ = 50:50, and were prepared in a similar method to that in Example 1, as a mixed powder to be used in the preparation of a metal-oxide vapor deposition material for the film formation of an underlayer.

A film-formed substrate was prepared with the use of the phosphoric acid vapor deposition material for the film formation of the hydrophilic layer, which was prepared by the method for Example 1, and was subjected to the measurement and evaluation, in a similar way to that in Example 1; and as a result, peeling of the hydrophilic layer did not occur, a contact angle after the wiping test was 11.3°, and in the observed screen, a ratio occupied by the foreign matter was less than 40%. In addition, a weight ratio between aluminum oxide and zirconium oxide in the formed underlayer was a ratio of Al₂O₃:ZrO₂ = 92.4:7.6.

### (Example 5)

Aluminum oxide (fine white powder, average particle size of 0.6 µm, and purity of 99.9% or more) and zirconium oxide (white powder, average particle diameter of 20 µm, and purity of 99.9% or more) were mixed at a weight ratio of Al₂O₃:ZrO₂ = 23:77, and were prepared in a similar method to that in Example 1, as a mixed powder to be used in the preparation of a metal-oxide vapor deposition material for the film formation of an underlayer.

A film-formed substrate was prepared with the use of the phosphoric acid vapor deposition material for the film formation of the hydrophilic layer, which was prepared by the method for Example 1, and was subjected to the measurement and evaluation, in a similar way to that in Example 1; and as a result, peeling of the hydrophilic layer did not occur, a contact angle after the wiping test was 18.6°, and in the observed screen, a ratio occupied by the foreign matter was 40% or more. In addition, a weight ratio between aluminum oxide and zirconium oxide in the formed underlayer was a ratio of Al₂O₃:ZrO₂ = 90.5:9.5.

### (Example 6)

Aluminum oxide (fine white powder, average particle size of 0.6 µm, and purity of 99.9% or more) and zirconium oxide (white powder, average particle diameter of 20 µm, and purity of 99.9% or more) were mixed at a weight ratio of Al₂O₃:ZrO₂ = 10:90, and were prepared in a similar method to that in Example 1, as a mixed powder to be used in the preparation of a metal-oxide vapor deposition material for the film formation of an underlayer.

A film-formed substrate was prepared with the use of the phosphoric acid vapor deposition material for the film formation of the hydrophilic layer, which was prepared by the method for Example 1, and was subjected to the measurement and evaluation, in a similar way to that in Example 1; and as a result, peeling of the hydrophilic layer did not occur, a contact angle after the wiping test was 6.6°, and in the observed screen, a ratio occupied by the foreign matter was 40% or more. In addition, a weight ratio between aluminum oxide and zirconium oxide in the formed underlayer was a ratio of Al₂O₃:ZrO₂ = 52.9:47.1.

### (Example 7)

Aluminum oxide (fine white powder, average particle size of 0.6 µm, and purity of 99.9% or more) and zirconium oxide (white powder, average particle diameter of 20 µm, and purity of 99.9% or more) were mixed at a weight ratio of Al₂O₃:ZrO₂ = 91:9, and were prepared in a similar method to that in Example 1, as a mixed powder to be used in the preparation of a metal-oxide vapor deposition material for the film formation of an underlayer.

A film-formed substrate was prepared with the use of the phosphoric acid vapor deposition material for the film formation of the hydrophilic layer, which was prepared by the method for Example 1, and was subjected to the measurement and evaluation, in a similar way to that in Example 1; and as a result, peeling of the hydrophilic layer did not occur, a contact angle after the wiping test was 18.1°, and in the observed screen, a ratio occupied by the foreign matter was less than 40%. In addition, a weight ratio between aluminum oxide and zirconium oxide in the formed underlayer was a ratio of Al₂O₃:ZrO₂ = 93.8:6.2.

### (Example 8)

Aluminum oxide (fine white powder, average particle size of 0.6 µm, and purity of 99.9% or more) and hafnium oxide (white powder, average particle diameter of 0.6 µm, and purity of 99.9% or more) were mixed at a weight ratio of Al₂O₃: HfO₂ = 80: 20, and were prepared in a similar method to that in Example 1, as a mixed powder to be used in the preparation of a metal-oxide vapor deposition material for the film formation of an underlayer.

A film-formed substrate was prepared with the use of the phosphoric acid vapor deposition material for the film formation of the hydrophilic layer, which was prepared by the method for Example 1, and was subjected to the measurement and evaluation, in a similar way to that in Example 1; and as a result, peeling of the hydrophilic layer did not occur, a contact angle after the wiping test was 18.0°, and in the observed screen, a ratio occupied by the foreign matter was 40% or more. In addition, a weight ratio between aluminum oxide and hafnium oxide in the formed underlayer was a ratio of Al₂O₃:HfO₂ = 94.8:5.2.

### (Example 9)

### <Preparation of antireflection film>

A BK-7 glass substrate (74.5 mm ϕ × 1.1 t), a SiO₂ vapor deposition material (particle size of 1 to 3 mm), a vapor deposition material for being used for the film formation of the underlayer and a vapor deposition material for being used in the film-formation of the hydrophilic layer, which were prepared in Example 1, were placed in a vacuum vapor deposition apparatus, and the inside thereof was decompressed by a vacuum pump while the BK-7 glass substrate was heated to a heating temperature of 200°C. After decompression to 2.0×10⁻³ Pa, a SiO₂ layer of 182 nm was formed on the BK-7 substrate at a film formation rate of 10 Å/sec. Next, the underlayer of 50 nm was formed on a substrate on which the SiO₂ layer was formed, and the hydrophilic layer of 98 nm was further layered, by a similar condition and method to that in Example 1. At this time, the refractive indices were 1.46 for the SiO₂ layer, 1.71 for the underlayer and 1.55 for the hydrophilic layer.

The measurement result of the reflectance at this time is shown in Fig. 3. The reflectance at a wavelength of 500 nm was approximately 1.4%, and an adequate antireflection film could be obtained.

In addition, the layered film which was incorporated in an optical design of the antireflection film having the underlayer and the hydrophilic layer can be prepared also on a substrate other than the BK-7 glass; and in the case of a polycarbonate substrate as an example of the plastic substrate, the design is such that the SiO₂ layer is 179 nm, the underlayer is 56 nm, and the hydrophilic layer is 95 nm in film thickness. In addition, in the case of an acrylic substrate, the SiO₂ layer is 167 nm, the underlayer is 88 nm, and the hydrophilic layer is 75 nm in film thickness. The antireflection film can have a design other than the above, and an adequate antireflection function can be obtained also in a multilayer film where the SiO₂ layer of 162 nm is formed on the BK-7 glass substrate, an Al₂O₃ layer (refractive index of 1.67) of 49 nm is formed, and then the underlayer of 49 nm and the hydrophilic layer of 75 nm are layered.

### (Example 10)

### <Preparation of network camera cover>

A network camera cover made from polycarbonate, a vapor deposition material for being used for the film formation of the underlayer and a vapor deposition material for being used for the film-formation of the hydrophilic layer, which were prepared in Example 1, were placed in a vacuum vapor deposition apparatus, and the inside thereof was decompressed by a vacuum pump while the camera cover was heated to a heating temperature of 50°C. After decompression to 2.0×10⁻³ Pa, the underlayer was film-formed by a similar condition and method to that in Example 1, and subsequently the hydrophilic layer was film-formed on the underlayer.

The vacuum vapor deposition apparatus was returned to the atmospheric pressure, the network camera cover was taken out and mounted on a main body of the network camera, and the main body 6 of the camera was covered with the camera cover in which a substrate 3, an underlayer 1 and a hydrophilic layer 2 were layered, as shown in Fig. 3. This was placed in the outdoor environment and was used for 40 days. After that, in the rain, video in the camera was checked, and as a result, attachment of water droplets was not shown in the image of the network camera also in the rain outdoor, and adequate visibility was maintained.

### (Comparative Example 1)

With the use of an aluminum oxide powder, a mixed powder for being used for the preparation of a metal-oxide vapor deposition material was prepared in a similar method to that in Example 1.

A film-formed substrate was prepared with the use of the phosphoric acid vapor deposition material which was prepared by the method for Example 1, and was subjected to the measurement and evaluation, in a similar way to that in Example 1; and as a result, a contact angle of the film-formed substrate after the wiping test was 20.3°, and in the observed screen, a ratio occupied by the foreign matter was 10% or less.

### (Comparative Example 2)

With the use of zirconium oxide, a mixed powder for being used for the preparation of a metal-oxide vapor deposition material was prepared in a similar method to that in Example 1.

A film-formed substrate was prepared with the use of the metal-oxide vapor deposition material which was prepared with the use of the mixed powder described above, and of the phosphoric acid vapor deposition material which was prepared by the method for Example 1, and was subjected to the measurement and evaluation, in a similar way to that in Example 1; and as a result, a contact angle of the film-formed substrate after the wiping test was 11.2°, and in the observed screen, a ratio occupied by the foreign matter exceeded 90%.

### (Comparative Example 3)

With the use of silicon oxide of which the electronegativity is different from that of oxygen by 1.7, a mixed powder for being used in the preparation of a metal-oxide vapor deposition material was prepared in a similar method to that in Example 1.

A film-formed substrate was prepared with the use of the metal-oxide vapor deposition material which was prepared with the use of the mixed powder described above, and of the phosphoric acid vapor deposition material which was prepared by the method for Example 1, and was subjected to the measurement and evaluation, in a similar way to that in Example 1; and as a result, a contact angle of the film-formed substrate after the wiping test was 24.8 °.

### (Comparative Example 4)

With the use of niobium pentoxide of which the electronegativity is different from that of oxygen by 1.6, a mixed powder for being used in the preparation of a metal-oxide vapor deposition material was prepared in a similar method to that in Example 1.

A film-formed substrate was prepared with the use of the metal-oxide vapor deposition material which was prepared with the use of the mixed powder described above, and of the phosphoric acid vapor deposition material which was prepared by the method for Example 1, and was subjected to the measurement and evaluation, in a similar way to that in Example 1; and as a result, a contact angle of the film-formed substrate after the wiping test was 39.4 °.

The metal-oxide vapor deposition materials, the weight ratios of the compounds (trivalent or hexavalent compound) of the metals which can be trivalent or hexavalent to the compounds (low electronegativity compound) of the metals of which the electronegativity is different from that of oxygen by 2.1 or more, in the underlayer vapor deposition films, and results of the measurement and evaluation, in the above Examples 1 to 8 and Comparative Examples 1 to 4, are shown in the following Table 1. As for the wiping test of the film-formed substrate in Table 1, the case was defined as ⊙ in which the contact angle was 10° or smaller, the case was defined as ○ in which the contact angle was more than 10° and 20° or smaller, and the case was defined as × in which the contact angle exceeded 20°. In addition, as for the appearance, the case was defined as ⊙ in which the ratio occupied by the foreign matter in the screen of the film-formed substrate observed by the manipulator was 40% or less, the case was defined as ○ in which the ratio was 90% or less, and the case was defined as × in which the ratio exceeded 90%.

In the present invention, the reason why the case was defined as × in which the contact angle exceeded 20° is because the evaluation criterion is set as a standard which indicates a high hydrophilic performance available in a wide industrial field; and a performance of 90° or smaller is generally defined as hydrophilic. Therefore, though depending on the intended application, a film-formed substrate of which the hydrophilic performance is approximately 60° in terms of the contact angle is practicable.

**[Table 1]**

| | Metal-oxide vapor deposition material | | XRF of film | Difference in electronegativity | Wiping test for substrate | | | | Moisture resistance test |
|---|---|---|---|---|---|---|---|---|---|
| | Component | Weight ratio between trivalent or hexavalent compound and low electro negativity compound | Weight ratio between components | Comparison with oxygen (3.5) | Initial contact angle | | Contact angle after test | | appearance |
| Example 1 | Al₂O₃+ZrO₂ | 83:17 | 92.4:7.6 | Zr:2.1 | 6.3 | ⊙ | 9.7 | ⊙ | ⊙ |
| Example 2 | Al₂O₃+ZrO₂ | 77:23 | 93.2:6.8 | Zr:2.1 | 8.3 | ⊙ | 9.4 | ⊙ | ⊙ |
| Example 3 | Al₂O₃+ZrO₂ | 67:33 | 93.1:6.9 | Zr:2.1 | 10.2 | ⊙ | 8.6 | ⊙ | ⊙ |
| Example 4 | Al₂O₃+ZrO₂ | 50:50 | 92.4:7.6 | Zr:2.1 | 4.9 | ⊙ | 11.3 | ○ | ○ |
| Example 5 | Al₂O₃+ZrO₂ | 23:77 | 90.5:9.5 | Zr:2.1 | 4.3 | ⊙ | 18.6 | ○ | ○ |
| Example 6 | Al₂O₃+ZrO₂ | 10:90 | 52.9:47.1 | Zr:2.1 | 12.7 | ○ | 6.6 | ⊙ | ○ |
| Example 7 | Al₂O₃+ZrO₂ | 91 : 9 | 93.8:6.2 | Zr:2.1 | 12.7 | ○ | 18.1 | ○ | ○ |
| Example 8 | Al₂O₃+HfO₂ | 80:20 | 94.8:5.2 | Hf:2.2 | 7.5 | ⊙ | 18.0 | ○ | ○ |
| Comparative Example 1 | Al₂O₃ | - | - | Al:2.1 | 4.7 | ⊙ | 20.3 | × | ⊙ |
| Comparative Example 2 | ZrO₂ | - | - | Zr:2.1 | 4.8 | ⊙ | 11.2 | ○ | × |
| Comparative Example 3 | SiO₂ | - | - | Si:1.7 | 4.1 | ⊙ | 24.8 | × | × |
| Comparative Example 4 | Nb₂O₅ | - | - | Nb:1.9 | 5.8 | ⊙ | 39.4 | × | × |

As described above in detail, according to the multilayer film having the underlayer and the hydrophilic layer of the present embodiment, it becomes possible to improve the sustainability of the antifogging performance as compared with a conventional hydrophilic film. Specifically, in the substrates shown as the Examples, the value of the contact angle indicates 20° or smaller even after the wiping test has been carried out; and in the substrate having such a contact angle, the characters are easy to read through the substrate fogged by exhalation, which means an excellent hydrophilic performance.

In the Examples described above, an example of production of the multilayer film by the vapor deposition method has been described, but the production method is not limited to the method; and for example, even to a multilayer film prepared by a sol-gel method, similar characteristics to those in the present invention can be imparted.

### [Reference Signs List]

1 Underlayer
2 Hydrophilic layer
3 Substrate
4 Multilayer film
5 Optical member
6 Main body of camera

## Claims

1. A multilayer film comprising:
an underlayer that is used for covering a surface of a substrate and is arranged on the surface of the substrate; and a hydrophilic layer that is layered on the underlayer, wherein
the underlayer contains aluminum oxide and zirconium oxide or hafnium oxide; a ratio of a weight of the zirconium oxide or hafnium oxide to a total weight of the zirconium oxide or hafnium oxide and the aluminum oxide is 50% or less; and the hydrophilic layer contains phosphoric acid.

2. An optical member comprising: a substrate; and a multilayer film that covers a surface of the substrate, wherein the multilayer film is the multilayer film according to claim 1.

## Patentansprüche

1. Mehrschichtiger Überzug, umfassend:
eine Unterschicht, die zum Abdecken einer Oberfläche eines Substrats verwendet wird und auf der Oberfläche des Substrats angeordnet ist; und eine hydrophile Schicht, die auf die Unterschicht geschichtet ist, wobei
die Unterschicht Aluminiumoxid und Zirconiumoxid oder Hafniumoxid enthält; ein Verhältnis eines Gewichts des Zirconiumoxids oder Hafniumoxids zu einem Gesamtgewicht des Zirconiumoxids oder Hafniumoxids und des Aluminiumoxids 50% oder weniger beträgt; und die hydrophile Schicht Phosphorsäure enthält.

2. Optisches Element, umfassend: ein Substrat; und einen mehrschichtigen Überzug, der eine Oberfläche des Substrats bedeckt, wobei der mehrschichtige Überzug der mehrschichtige Überzug nach Anspruch 1 ist.

## Revendications

1. Film multicouche comprenant :
une sous-couche qui est utilisée pour couvrir une surface d'un substrat et qui est disposée sur la surface du substrat ; et une couche hydrophile qui est stratifiée sur la sous-couche,
dans lequel la sous-couche contient de l'oxyde d'aluminium et de l'oxyde de zirconium ou de l'oxyde de hafnium ; le rapport du poids de l'oxyde de zirconium ou de l'oxyde de hafnium au poids total de l'oxyde de zirconium ou de l'oxyde de hafnium et de l'oxyde d'aluminium est de 50 % ou moins ; et la couche hydrophile contient de l'acide phosphorique.

2. Elément optique comprenant : un substrat ; et un film multicouche qui couvre une surface du substrat, dans lequel le film multicouche est le film multicouche selon la revendication 1.
